# EUROPEAN PATENT APPLICATION

(11) **EP 4 180 886 A1**
(43) Date of publication of application: **17.05.2023**
(21) Application number: 21208595.5
(22) Date of filing: 16.11.2021
(51) Int. Cl.: G05B 19/042, B23K 26/00, G05B 19/12, H05K 3/00, G06Q 50/04, H05K 1/02

(54) **DRILLING AUTOMATION SYSTEM FOR COMPONENT CARRIER STRUCTURES**

(71) Applicant: AT&S Austria Technologie & Systemtechnik Aktiengesellschaft, 8700 Leoben (AT)
(72) Inventor: Habenbacher, Heinz, 8792 St. Peter-Freienstein (AT); Gross, Christoph, 8700 Leoben (AT)
(74) Representative: Dilg, Haeusler, Schindelmann Patentanwaltsgesellschaft mbH

(57) **Abstract**

The present invention relates to an apparatus (100) for drilling component carrier structures. The apparatus (100) comprises a drilling stage (120) configured for drilling the drilling component carrier structures (101) according to a drilling process and a fixing system comprising a stage fixation configured for fixing and/or aligning the component carrier structures (101) in the drilling stage (120). The apparatus (100) further comprises a tracing system (102) for tracing data deriving from at least one of the component carrier structures (101), the fixing system and the drilling process, and a communication system (160) associated to the tracing system (102), wherein the communication system (160) is configured to manage the tracing data acquired by the tracing system (102).

## Description

### Technical Field

The present invention relates to an apparatus and a method for drilling component carrier structures.

### Background

Component carriers, for example printed circuit boards (e.g. PCBs), are equipped with one or more components. Hence, the manufacturing accuracy and the quality of the component carriers has to be increased, especially due to the need for increasing miniaturization of such elements as well as due to a rising number of parts to be connected to such carriers. Furthermore, component carriers shall be mechanically robust and electrically reliable to be operable even under harsh conditions, as more and more functions are integrated within a component carrier.

Component carriers comprise a plurality of stud holes or through holes, that is vias, formed by mechanical or by laser drilling. Taking into account that the location of the holes has to be very precise, as the number of holes increases and the more complex the component carriers are designed, complex drilling machines are needed. To drill precisely a detailed and exact drill hole pattern into a component carrier, such carriers have to be exactly located and aligned in the drilling machine. Additionally, different kinds of component carriers comprise different patterns of drilled holes, for this reason, such adaption of the drilling machine to the desired drilled hole pattern has to be provided. Hence, first the operator should assess as to which drill pattern should be drilled in the component carrier. Second, it is necessary an exact alignment of the component carrier, in such a way that the drilling machine is able to perform the holes at the desired location with the sought drilled hole pattern. However, a plurality of initial steps are necessary, such as programming of the drilling machine with the desired or hole pattern and the handling and aligning of the component carriers. Consequently, the drilling process for the component carriers is time-consuming and prone to failures.

Furthermore, besides the desired drilled hole pattern of the component carrier, no further information about the drilling process and the batch of a plurality of component carriers that are drilled by the machine are provided by conventional drilling machines. Thereafter, if failures occur at a later stage or in the further processing of the component carriers or yet in the use of such carriers, there is no documentation about the drilling process, in which the respective drilled holes have been drilled. In consequence, if an error occurred during the drilling step it would not be possible to retrace it later on, for example.

Accordingly, there may be a need to provide a more efficient and re-traceable drilling process for drilling holes in a component carrier.

### Summary

The object of the invention is to provide a more efficient and re-traceable drilling process for drilling holes in a component carrier.

This aim is achieved by using an apparatus for drilling component carrier structures and a method of drilling component carriers according to the independent claims.

According to first aspect of the present invention, an apparatus for drilling component carrier structures is presented. The apparatus comprises a (e.g. laser or mechanical) drilling stage configured for drilling component carrier structures according to a drilling process. The apparatus further comprises a fixing system comprising a stage fixation (such as a clamping device or a vacuum suction fixation) configured for fixing and/or aligning the component carrier structures in the drilling stage.

The apparatus further comprises a tracing system for tracing data deriving from at least one of the component carrier structures, the fixing system and the drilling process. Furthermore, the apparatus comprises a communication system associated to the tracing system, wherein the communication system is configured to manage the tracing data acquired by the tracing system.

According to a further aspect, a method of drilling component carrier structures in an automated way (i.e. without any human interaction between loading and unloading to or from the apparatus). The method comprises a fixing and/or aligning the component carrier structures in a drilling stage by a drilling stage fixation of a fixing system, and a drilling of component carrier structures in the drilling stage. Furthermore, according to the method, tracing data are derived from at least one of the component carrier structures, the fixing system and the drilling process. Tracing data are interchanged by a communication system associated to the apparatus configured to manage said tracing data.

In the context of the present application, the term "component carrier structure" may particularly denote any support structure which is capable of accommodating one or more components, such as electronic components thereon and/or therein for providing mechanical support and/or electrical connectivity for electronic circuits or components. In other words, a component carrier structure may be configured as a mechanical and/or electronic carrier for components. In particular, a component carrier structure may be one of a printed circuit board, an organic interposer, a metal core substrate, an inorganic substrate, and an IC (integrated circuit substrate). A component carrier structure may also be a hybrid board combining different ones of the above-mentioned types of component carriers. Hence, according to an exemplary embodiment, the component carrier structures are selected from a group consisting of panels, arrays, and component carriers, in particular printed circuit boards or integrated circuit substrates. The component carrier structure may have a sheet (plate) like design comprising two opposing main surfaces. The main surfaces form the two largest surface areas of the component carrier structure. The main surfaces are connected by circumferential side walls. The thickness of a component carrier structure is defined by the distance between the two opposing main surfaces. The main surfaces may comprise functional sections, such as conductive traces or conductive interconnections with further elements, such as ICs.

For fixing the component carrier structures during drilling, the component carrier structures are fixed in the drilling stage by the fixing system, in particular by vacuum and under pressure and/or by mechanical fixation (clamps), respectively.

The tracing data may be for example the product data of the component carrier structure, the parts (id) number of the component carrier, alignment data of the of the component carrier structure on a carrier and/or in the drilling stage, data regarding drill hole position, (measured) drill hole pattern, environmental conditions during drilling (e.g. humidity, temperature).

The communication system may be coupled wireless or wire bond with the tracing system, the drilling stage and the fixing system, for example, in order to interchange the tracing data.

The communication system processes and therefore manages the tracing data. Managing the tracing data means to evaluate, if the tracing data, e.g. the correct parts (id) number is loaded into the drilling stage. Furthermore, the communication system manages and evaluates, if the correct predetermined environmental conditions are met during drilling, for example. Furthermore, the communication system manages, e.g. processes and transmits, the tracing data to the respective recipient (such as the loading or unloading unit, the flipping unit or a subsequent processing stage), such that based on the communicated tracing data, respective actions (such as refusal defect of fail drilled component carrier structures) can be initiated. The communication system is associated to the tracing system by its association with the apparatus.

By the approach of the present invention an apparatus for drilling component carrier structures is provided, wherein automated drilling process can be conducted and wherein an improved quality control and documentation through the complete drilling process can be provided.

According to an exemplary embodiment, wherein the tracing system is configured for tracing the association between the component carrier structures and the drilling process in the apparatus for ensuring that
(i) correct component carrier structures are supplied to the apparatus for loading,
(ii) a correct (laser or mechanical) drilling process is carried out for drilling a respective component carrier structure,
(iii) a drilling process for drilling component carrier structures is documented, and
(iv) correct component carrier structures are unloaded from the apparatus.

According to an exemplary embodiment, the communication system is configured for interchanging tracing data, wherein the tracing data relates to the association between the component carrier structures and the drilling process, wherein the tracing data comprises information to determine if:
(i) predetermined component carrier structures are supplied to the apparatus for loading,
(ii) a predetermined drilling process is carried out for drilling the respective component carrier structure,
(iii) a drilling process for drilling component carrier structures is documented, and/or
(iv) predetermined component carrier structures are unloaded from the apparatus.

According to an exemplary embodiment, in the drilling stage, drilling units are provided to apply drilling pattern to the component carrier structure. For example, the plurality of drilling units may be laser drilling units for providing a plurality of drilling laser beams. Furthermore, the plurality of drilling units may be mechanical drilling units having a plurality of mechanical drill bits for forming drilling patterns to the component carrier structure.

According to an exemplary embodiment, the tracing data comprises environmental conditions, in particular temperature, humidity, pressure, partial oxygen pressure, are evaluatable from at least one of the loader unit, the drilling stage, the unloading unit and the flipping unit.

The tracing information of the tracing data comprises the specific type of component carrier structures e.g. loaded in the loader unit. Furthermore, the tracing information comprises for example the part number and serial number, respectively, of the component carrier structure. Furthermore, the tracing information defines the kind of drilling process, for example, which hole pattern, hole sizes, and drilling speed, is to be applied for the drilling process of the specific component carrier structure. Furthermore, tracing information may comprise operational parameters, such as laser beam or drill bit parameters of the drilling stage during drilling, environmental conditions, such as the temperature or the humidity of the environment during the drilling process. Hence, the tracing information comprises the specific data for identifying the respective component carrier structure as well as operational parameters defining the environment during the drilling procedure as well as the applied drilling program, for example.

According to an exemplary embodiment, the apparatus further comprises a loader unit configured for loading component carrier structures for (laser or mechanical) drilling into the apparatus, wherein the loader unit is coupled to the communication system for interchanging tracing data.

For example, the component carrier structures may be provided in magazines that comprise a plurality of carriers supporting a respective component carrier structure. The magazines may be arranged in movable trolleys that can be moved to the loader unit.

The loader unit comprises a respective loader, such as a manipulator, for gripping the respective component carrier structure or a respective carrier supporting one or a plurality component carrier structure and for arranging and aligning the component carrier structure within the loader unit at an initial location. At the initial location in the loader, the component carrier structure is correctly aligned and prepared for further movement to the drilling stage. The loader may for example align the component carrier structure by translation and rotation of the respective component carrier structure until a desired alignment is achieved.

The further movement to the drilling stage is provided by a handling unit, such as a conveyor belt or a manipulator. The manipulator for example grips the component carrier structure and moves the component carrier structure to the drilling stage. By the manipulator, a respective alignment of the component carrier structure and the drill support, respectively, can be made. The tracing system may comprise sensors for receiving and determining the tracing data from a component carrier structure and/or a carrier. For example, in the loader unit, the drilling stage and the unloading unit respective position sensors of the tracing system, such as camera sensors, may be installed in order to measure the orientation and alignment of the component carrier structure.

The sensors (e.g. inspection cameras) may also measure the diameter of the drilled holes. This information may also be transmitted by the control unit to a subsequent processing machine, such as a plating unit to support the plating unit with that information to apply best plating conditions.

The tracing system comprises a plurality of parts (sensors) installed at the several stages of the apparatus. The parts are for example detector devices, such as an optical or magnetic detector device which are configured for scanning and detecting respective identifiers of the component carrier structures. The detector devices may be cameras or RFID readers. The component carrier structures may pass the detector device with a constant speed or sequentially. Furthermore, the detector devices may comprise an actuator for pivoting or laterally moving the detector device. Hence, the actuator may adjust the respective detector device, such that the detector device may follow the movement of the component carrier structure, for example.

A part of the tracing system for tracing the component carrier structures is installed in the loader unit. The tracing system and the loader unit are configured for identifying the component carrier structures that are supplied to the loader unit. Therefore, the tracing system comprises respective detectors for detecting respective tracing information about the component carrier structures loaded in the loader unit.

The handling unit moves the component carrier structure from the loader unit to the drilling stage after for example the tracing system ensures that the correct and desired component carrier structure to be inserted in the drilling stage is provided. The handling unit arranges and aligns the component carrier structure in a predefined position within the drilling stage.

The drilling stage may be configured for drilling a bore hole pattern in the component carrier structure by laser drilling or by mechanical drilling. For example, one at a time or a plurality of component carrier structures can be treated by the drilling process simultaneously. For example, by using a laser drilling device, a short laser pulse with high power density may feed energy into the component carrier structure quickly, causing the material of the component carrier structure to melt and vaporize. By the laser drilling device one or a plurality of drilling holes may be drilled simultaneously by a plurality of laser pulses.

The drilling stage comprises a further part of the tracing system for example a further detector, for detecting tracing information about the component carrier structure that is treated with drilling. For example, the tracing system detects the part number and serial number, respectively, of the component carrier structure. Furthermore, the tracing system receives tracing information from the drilling stage, which kind of drilling process, for example, which hole pattern, hole sizes, and drilling speed is to be applied for the drilling process of the specific component carrier structure.

According to an exemplary embodiment, the apparatus further comprises an unloading unit configured for unloading drilled component carrier structures out of the apparatus (e.g. out of the drilling state and /or a flipping unit). The unloading unit is coupled to the communication system for interchanging tracing data.

After drilling the drilled hole pattern to the component carrier structure, a conveyor belt or a further handling unit moves the component carrier structure including the drilling holes from the drilling stage to the unloading unit. The handling unit arranges and aligns the component carrier structure in a predefined position within the unloading unit. As described below in further detail, between the drilling stage and the unloading unit, a flipping unit for flipping component carrier structures and/or an inspection unit may be arranged.

The unloading unit comprises a respective loader, such as a manipulator, for gripping the respective component carrier structure or a respective carrier supporting the component carrier structure and for moving the component carrier structure to the desired location, such as a magazine and/or a carrier for supporting the component carrier structure.

Additionally, a further part of the tracing system for tracing the component carrier structures is installed in the unloading unit. The tracing system is configured for identifying the component carrier structure delivered from the drilling stage and for identifying for example the magazine to which the respective component carrier structure has been delivered. Hence, a subsequent manufacturing stage, such as a plating system for plating the drilled through holes, receives tracing information about which batch of component carrier structures arrived from the drilling stage.

Summarizing, by the tracing system quality control and documentation about the complete drilling stage are provided. The tracing system ensures that the desired and correct component carrier structures are input in the drilling stage. Furthermore, the tracing system ensures that due to the known provided component carrier structure, the correct drilling program is used for drilling the desired drill hole patterns to the component carrier structures. Additionally, since at all stages, in particular in the loader unit, the drilling stage, and the unloading unit, respective parts of the tracing system are installed, complete documentation of the drilled component carrier structure is provided. Furthermore, since all tracing information received by the tracing system can be used for the complete drilling stage, an automatic control of the complete drilling process can be provided. Furthermore, a further check e.g. by an operator between the stages, such as between the loader unit and the drilling stage, is no longer necessary, since all necessary tracing information is detected and received by the tracing system on which basis of the desired control command can be given, such as the selection of the correct drilling program.

According to a further exemplary embodiment, the tracing system is configured for tracing a respective component carrier structure by reading an identifier from the component carrier structure. The identifier may be for example located on each component carrier structure or a carrier supporting the component carrier structure. Furthermore, the identifier may be formed on a surface of the component carrier structure or the carrier. Alternatively, the identifier may be formed below the surface and inside of the respective component carrier structure or carrier. The tracing system comprises a respective detector, such as a camera an RFID reader, for detecting the tracing information characterizing the component carrier structure. The identifier may also comprise antenna elements on the edges of the panel or the drill support to use it as an RFID tag.

According to a further exemplary embodiment, the identifier is at least one of the groups consisting of a QR code, a barcode, and an alphanumeric code. The tracing system may be connected to the control unit or to a respective database for identifying the respective tracing information for tracing component carrier structure. For example, based on the determined identifier, the respective constitution of the component carrier structure and the drilled hole pattern to be drilled can be selected.

According to a further exemplary embodiment, the tracing system is configured for tracing the tracing data of a carrier carrying a plurality of component carrier structures to be drilled. For example, a carrier may support a plurality of respective component carrier structures. The carrier itself may be arranged in the magazine of a movable trolley that can be moved to e.g. the loader unit. The component carrier structure may be moved together with the carrier through the apparatus. Alternatively, the loader unit may be fed by a single component carrier structure without the carrier. The carrier may be arranged outside of the loader unit and may be moved to the unloading unit, where the carrier receives again the drilled component carrier structure. The tracing system thereby detects for example an identifier on the carrier and the identifier of the component carrier structures, for example. Hence, the tracing system documents, which kind of component carrier structures are loaded in the respective carrier.

According to a further exemplary embodiment, the tracing system is configured for tracking the carrier by reading an RFID tag of the carrier.

According to a further exemplary embodiment, the apparatus further comprises a flipping unit configured for flipping a component carrier structure upside down after having drilled one main surface and before drilling the opposing surface of the respective component carrier structure. For example, the component carrier structure is treated with the mechanical or laser drilling in the drilling stage, in such a way that the mechanical or laser drilling unit drills from the upper or lower surface of the component carrier till a predefined depth of the drilled hole is reached. To form a complete through hole, the component carrier structure may be moved out of the drilling unit into the flipping unit. In the flipping unit, the component carrier structure is flipped around and is moved back into the drilling unit. The flipped component carrier structure is aligned to the drilling unit. Next, the drilling unit treats the other surface of the component carrier structure till the drilled hole is reached and a through hole is made. After the desired drill hole pattern is drilled by the drilling stage, the flipped component carrier structure may be moved directly to the unloading unit or may be moved through the flipping unit into the unloading unit. The flipping unit may hold the component carrier structure and the drill support and flip both around. The flipping unit may comprise a suction cup for holding the component carrier structure (and e.g. the drill support) by underpressure. Furthermore, the flipping unit may comprise mechanical clamps for clamping the component carrier structure and the drill support during flipping.

Additionally, a further part of the tracing system is installed in the flipping unit. Hence, the tracing system detects, if the component carrier structure in the flipping unit has already been flipped around or whether it is not necessary to flip the component carrier structure, so that the component carrier structure may move through the flipping unit into the unloading unit. Hence, due to the use of the tracing system, it is for example not necessary, that an operator proves if the component carrier structure has to be flipped around or as to be moved on to the unloader device.

According to a further exemplary embodiment, the loader unit is configured to place and align the component carrier structure onto a drill support, wherein the drill support is configured for being moved with the component carrier structure through the drilling stage. In particular the component carrier structure is arranged with its main surface onto the drill support for reducing the risk of warpage.

In an exemplary embodiment, the drilling stage comprises a fixing table, in particular a vacuum suction table, wherein the drill support is fixable to the fixing table during drilling. The component carrier structure may also be fixed by a clamp to the drill support to ensure high accuracy drilling. To protect the drilling machine the drill support may be used, which acts as a stop layer against laser drill beams or mechanical impact of the drill bits. However, at a certain point the drill support may also be damaged by the laser beam or a drill bit. The integrated camera system and in corporation with the control unit may detect the damaged drill support and e.g. at the flipping station the drill support could be exchanged with a new one to ensure high accuracy at the drilling process.

According to a further exemplary embodiment, the apparatus further comprises drill support exchange units configured for exchanging drill support to be interposed between a vacuum suction table and a component carrier structure during drilling. According to a further exemplary embodiment, one drill support exchange unit is coupled to the loader unit and/or to the drilling stage for providing drill support to the drilling stage.

According to a further exemplary embodiment, one drill support exchange unit is coupled to the unloading unit and/or to the drilling stage for receiving a drill support from the drilling stage. For example, the drilling laser is triggered to stop, when the laser hits unintentionally the drill support. If the drill support is damaged, the damaged drill support can be exchanged upon detection of a damage or at a predefined maintenance time (e.g. if the drill support was used for e.g. 50 drilling cycles). Hence, the component carrier structure and the drill support are fed separately to the loader unit.

According to a further exemplary embodiment, the tracing system comprises a drill support inspection unit for inspecting the drill support, wherein the drill support inspection unit is coupled to the drill support exchange unit such that upon a defect of the drill support is detected, the drill support is replaced by the drill support exchange unit. By the drill support inspection unit, the status (e.g. defects) of the drill support and also defects (e.g. warpage) of the component carrier structure can be detected before entering into the loader unit and before the component carrier structure is placed onto the drill support.

For fixing the component carrier structures during drilling, the component carrier structures are fixed onto drill support by the fixing system, in particular by vacuum and under pressure and/or by mechanical fixation (clamps), respectively. Hence, the drill support comprises vacuum through holes that are covered on one side by the component carrier structure which is located onto the drill support. The drilling support itself is arranged onto the surface of a vacuum suction table. The vacuum suction table comprises respective through holes that are coupled to a vacuum pump. Specifically, the through holes of the drill support match with the through holes of the vacuum suction table. Hence, upon applying under pressure, the drill support as well as the component carrier structure is sucked to the vacuum suction table and may therefore be fixed in the desired position. The drill supports are removably located onto the vacuum suction table, so that the drill supports may be exchanged, if the drill supports are damaged for example by the drilling process or if different kinds of component carrier structure have to be drilled that makes different drill support necessary. By the applied vacuum, which is holding down the component carrier structure, a cleaning effect of the drilled through hole occurs when it is drilled e.g. the second time after flipping. Due to the vacuum flow (e.g. the turbulent flow) which is created, less or in best case no residue remains in the drilling hole. Hence, a desmear process step during manufacturing may be avoided.

Therefore, a first inlet drill support exchange unit for providing the drill support and a further outlet drill support exchange unit for receiving the drill support are coupled directly or indirectly to the drilling stage.

After a predefined number of processed component carrier structures, the drill supports can be automatically exchanged. This may be required due to the reason that the surface of the drill support is damaged during processing, e.g. during treatment with the laser beams during drilling. Therefore, a position for new and used drill support may be integrated into the apparatus. For example, informed via the horizontal interface communication, for example by a manipulator or a conveyor belt, the new and used drill support may be transported to or from the drilling machine and provide an individual exchange of respective drill supports.

According to a further exemplary embodiment, an inspection unit is configured for presenting a component carrier structure for visual inspection to a user after the first part of drilling. According to a further exemplary embodiment the inspection unit is further configured for providing a visual inspection to a user after flipping the component carrier structure and before the unloading unit, e.g. after the complete drilling process. For example, the inspection unit is arranged within the drilling stage, such that a user or operator can visually inspect if the drill holes are correctly drilled. The inspection unit is also able to measure the warpage of a component carrier structure. If warpage is detected, the component carrier structure (e.g. a panel) is not further processed. Warpage may occur also during drilling because lot of heat is introduced into the panel.

The inspection unit may be formed for example by a transparent section allowing to watch inside the drilling stage. Furthermore, the inspection unit may be a separate unit that may receive the component carrier structure. For example, after the drilling stage, the component carrier structure to be reviewed can be separated from the manufacturing line of the apparatus and can be arranged inside the separate inspection unit. Hence, while inspecting the extracted component carrier structure, the component carrier structures may be processed, i.e. drilled, and further moved to the flipping and/or the unloading. After the operator has inspected the component carrier structure, the component carrier structure may be put back in the general drilling procedure. The through hole pattern will be inspected from both sides of the component carrier structure. An offset between the drilled holes reduces the reliability of the z-interconnections or a signal transport trough the drilled hole. Thus, the visual inspection in the inspection unit ensures a proper alignment of the drill holes to reduce offsets and increase the reliability of the entire stack. The inspection unit may also comprise a camera, such as a high-resolution camera or a Xray-camera. The inspection pictures are compared e.g. in a (UCAM) system. For example, a present real arrangement of the drilled holes in the component carrier structure can be inspected and based on the real hole pattern on one side, the other side of the component carrier structure can be drilled, wherein the drill hole pattern is adjusted to the drill hole pattern of the other side to reduce offset.

Summarizing, after the predefined number of processed component carrier structures, a continuous quality control, such as visual inspection, can be conducted. Therefore, the apparatus according to the present invention separates a component carrier structure from the main production line and places them into the inspection unit. Subsequently, an operator can extract the component carrier structures from the process for quality control. During the inspection, the drilling machine is able to continue processing. After the check, the extracted component carrier structure can be returned to the process, respectively.

According to a further exemplary embodiment, the apparatus comprises the above-described handling unit configured for handling the component carrier structures between the loader unit, the unloading unit, the drilling stage, the flipping unit, the inspection unit, and the tracing system. The handling unit may be a conveyor belt or a manipulator. The manipulator for example grips the component carrier structure and moves the component carrier structure to the drilling stage.

According to a further exemplary embodiment, the apparatus further comprises a control unit coupled to the communication system for controlling the loader unit, the drilling stage, the fixation system, flipping unit and the unloading unit. The control unit is coupled to the tracing system for controlling the loader unit, the drilling stage, the fixation system, the flipping unit and the unloading unit based on the tracing information determined by the tracing system. Additionally, the control unit may be coupled to the flipping unit for controlling the flipping of a component carrier based on the tracing information received by the tracing system. Furthermore, the control unit may be coupled to the inspection unit. Hence, the control unit may control a handling unit to move a component carrier structure after the drilling stage to the inspection unit for inspecting the quality of the drilled holes. At the same time, the control unit may control the drilling stage unit, such that simultaneously to the inspection the drilling of further component carrier structures further proceed. The control unit is coupled for signal transfer at least with one of the loader unit, the unloading unit, the flipping station, the drilling stage, the handling unit, the inspection unit, the respective drill support exchange unit. The control unit may be coupled to the respective unit wireless. Furthermore, the control unit may also be coupled to and therefore communicate with other machines in a manufacturing line.

According to a further exemplary embodiment, the tracing system comprises a detector device, in particular an inspection camera, for determining at least one of a diameter of the bore holes drilled in the component carrier structure and warpage of the component carrier structure or the drill support.

According to a further exemplary embodiment, the communication system is coupled to a subsequent processing system, such as a subsequent plating unit, for providing the information about the component carrier structure. For example, information about the true and exact hole diameter of the through holes drilled in the drilling stage in a specific traceable component carrier structure can be provided to a subsequent plating line. Furthermore, the control unit may also comprise a user interface (such as a keyboard and a monitor) to manually control the apparatus by an operator.

Hence, a fully automated drilling process for substrate production (e.g. a component carrier structure) may be provided. By the tracing system, a fully automated unit (such as the loader unit), the drilling stage, or the unloading unit, continuous process multiple of production jobs without downtime if the drilling machine.

Furthermore, by the present invention, a traceability concept is provided. The component carrier structures are tracked within the whole drilling process. Therefore, at each gate between for example in the loader unit, the drilling stage, and the unloading unit, the tracing system determines, an identification code which is validated with an integrated visual system based on information of the manufacturing execution system (i.e. the tracing system). Also component carrier structures that are extracted from the main process, for example for quality control, can be put back into the process before and after the respective manufacturing stages. In case of a processing error, the component carrier structure will be marked NG ("not good") and automatically separated from the main production line.

According to the apparatus and the method putting to the present invention, a following exemplary process flow may be provided. First of all, at the load port unit, the carrier or the component carrier structure supported in the carrier will be handed over it. Next, the tracing system reads a RFID tag on the carrier or the component carrier structure. Next, the component carrier structure may be picked from the carrier. Next, the identification information (ID) and the tracking information, respectively, are read and validated.

In the loader unit, a pre-alignment for hand over the component carrier structures to the drilling stage is done and afterward, the component carrier structure is loaded to the drilling stage. Next, specifically, a first layer of the component carrier structure is processed before the component carrier structure is unloaded from the drilling stage. Next, the tracking information are read (e.g. the panel ID) to validate the drilled component carrier structure. Next, in a flipping unit, the component carrier structure may be flipped and moved back into the drilling stage. Next, the component carrier structure is picked from the carrier and unload port and the tracing system reads tracing information of the component carrier structure. Furthermore, a pre-alignment of the component carrier structure is provided for the hand over to the drilling stage. Next, the second opposed surface of the component carrier structure is drilled. Next, the component carrier structure is unloaded from the drilling stage and an ID reading/validation, for example reading the tracing information, is done. Next, drilling of the second opposed surface is done. After the desired drilled hole pattern is made to the component carrier structure, the component carrier structures are unloaded from the drilling stage and the tracing system can read the ID. Next, the component carrier structure is placed on a respective carrier in the unloading unit and will therefore be prepared for further transport.

It has to be noted that embodiments of the invention describe different subject matters. In particular, some embodiments refer to apparatus type claims whereas other embodiments have been described concerning method type claims. However, a person skilled in the art will gather from the above and the following description that, unless other notified, in addition to any combination of features belonging to one type of subject matter also any combination between features relating to different subject matters, in particular between features of the apparatus type claims and features of the method type claims is considered as to be disclosed with this application.

### Brief Description of the Drawings

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.
Fig. 1 illustrates a schematic view of an apparatus for drilling component carrier structures according to an exemplary embodiment.
Fig. 2 illustrates a schematic view of a vacuum suction table holding component carrier structure in a drilling stage according to an exemplary embodiment.

### Detailed Description

The illustrations in the drawings are schematic. In different drawings, similar or identical elements are provided with the same reference signs.

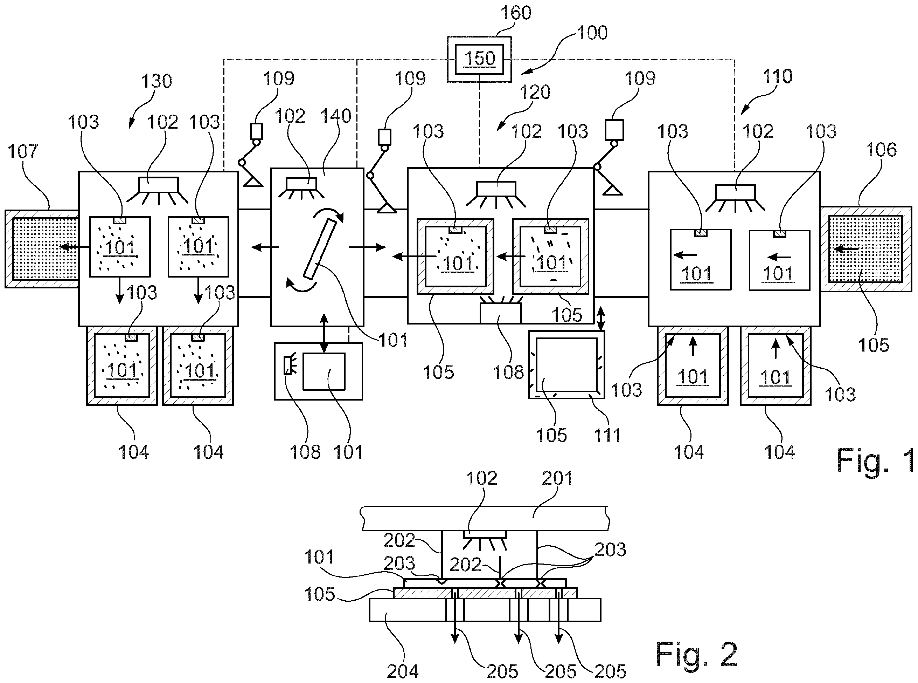

**Fig. 1** illustrates a schematic view of an apparatus 100 for drilling component carrier structures 101 according to an exemplary embodiment.

The apparatus 100 comprises a (e.g. laser or mechanical) drilling stage 120 configured for drilling component carrier structures 101 according to a drilling process. The apparatus 100 further comprises a fixing system comprising a stage fixation 205 (see Fig. 2) (such as a clamping device or a vacuum suction fixation) configured for fixing and/or aligning the component carrier structures 101 in the drilling stage 120. The apparatus 100 further comprises a tracing system 102 for tracing data deriving from at least one of the component carrier structures 101, the fixing system and the drilling stage 120. Furthermore, the apparatus 100 comprises a communication system 160 associated to the tracing system 102, wherein the communication system 160 is configured to manage the tracing data acquired by the tracing system 102.

Furthermore, the apparatus 100 comprises a loader unit 110 configured for loading component carrier structures 101 for drilling into the apparatus 100. Furthermore, the apparatus comprises an unloading unit 130 configured for unloading drilled component carrier structures 101 out of the apparatus 100.

The tracing system 102 is configured for tracing the component carrier structures 101 in the apparatus 100 for ensuring that (i) correct component carrier structures 101 are supplied to the apparatus 100 for loading, (ii) a correct drilling process is carried out for drilling a respective component carrier structure 101, (iii) a drilling process for drilling component carrier structures 101 is documented and (iv) correct component carrier structures (101) are unloaded from the apparatus (100).

The tracing data may be for example the product data of the component carrier structure, the parts (id) number of the component carrier, alignment data of the of the component carrier structure on a carrier and/or in the drilling stage, data regarding drill hole position, (measured) drill hole pattern, environmental conditions during drilling (e.g. humidity, temperature).

The communication system 160 may be coupled wireless or wire bond with the tracing system 102, the drilling stage 120 and the fixing system, for example, in order to interchange the tracing data.

The communication system 160 processes and therefore manages the tracing data. The communication system 160 processes and transmits the tracing data to the respective recipient (such as the loader or unloading unit 110, 130, the flipping unit 140 or a subsequent processing stage), such that based on the communicated tracing data, respective actions (such as refusal defect of fail drilled component carrier structures 101 can be initiated.

The component carrier structures 101 are provided in magazines that comprise a plurality of carriers 104 supporting one or a plurality respective component carrier structures 101. The magazines may be arranged in movable trolleys that can be moved to the loader unit. In the present example, two carriers 104 may be arranged side by side, such that two component carrier structures may be provided to the loader unit 110 at the same time.

The loader unit 110 comprises a respective loader, such as a manipulator, for gripping the respective component carrier structure 101 or a respective carrier 104 supporting one or a plurality component carrier structures 101. The loader arranges and aligns the component carrier structure 101 within the loader unit 110 at an initial location. At the initial location in the loader unit 110, the component carrier structure 101 is correctly aligned and prepared for further movement to the drilling stage 120.

A handling unit 109, such as a manipulator, grips the component carrier structure 101 and moves the component carrier structure 101 to the drilling stage 120.

Additionally, part or unit of the tracing system 102 for tracing the component carrier structures 101 is installed in the loader unit 110. The tracing system 102 comprises respective detectors for detecting respective tracing information about the component carrier structures 101 loaded in the loader unit 110.

The handling unit 109 moves the component carrier structure from the loader unit 110 to the drilling stage 120 after for example the tracing system 102 ensures that the correct and desired component carrier structure 101 to be inserted in the drilling stage 120 is provided. The handling unit 109 arranges and aligns the component carrier structure 101 in a predefined position within the drilling stage 120.

The drilling stage 120 comprises drilling devices 201 (see Fig. 2) for drilling a respective drilled hole pattern in the component carrier structure 101. For example, one at a time or two component carrier structures 101 as shown in Fig. 1 can be treated by the drilling process simultaneously.

The drilling stage 120 comprises a further part/unit of the tracing system 102, for example, a further detector, for detecting further tracing information about the component carrier structure 101 that is treated with drilling. For example, the tracing system 102 detects the part number and serial number, respectively, of the component carrier structure 101. Furthermore, the tracing system 102 receives tracing data information from the drilling stage 120, which kind of drilling process, for example, laser or mechanical drilling, which hole pattern, hole sizes, and drilling speed, is applied for the drilling process of the specific component carrier structure 101.

After drilling the drilled hole pattern to the component carrier structure 101, a conveyor belt or a further handling unit 109 moves the component carrier structure 101 including the drilling holes from the drilling stage 120 to a flipping unit 140 configured for flipping a component carrier structure 101 upside down after having drilled one main surface and before drilling the opposing other main surface of the respective component carrier structure 101. For example, the component carrier structure 101 is treated with the drilling in the drilling stage 120, such that the laser or drill bit drills from the upper or lower surface of the component carrier structure 101 till a predefined depth of the drilled hole is reached. In order to form a complete through hole of the drilled hole, the component carrier structure 101 may be moved out of the drilling stage 120 into the flipping unit 140. In the flipping unit 140, the component carrier structure 101 is flipped around and is moved back afterward into the drilling stage 120. Next, the drilling device 201 in the drilling stage 120 treats the other surface of the component carrier structure 101 till the drilled hole is reached and a through hole is made. After the desired drill hole pattern is drilled by the drilling stage 120, the flipped component carrier structure 101 may be moved through the flipping unit 140 into the unloading unit 130.

Furthermore, a further part/unit of the tracing system 102 is installed in the flipping unit 140. Hence, the tracing system 102 detects, if the component carrier structure 101 in the flipping unit 140 has already been flipped around or if it is not necessary to flip the component carrier structure 101, so that the component carrier structure 101 moves through the flipping unit 140 into the unloading unit 130.

After passing the flipping unit 140, the unloading unit 130 is arranged. The handling unit 109 arranges and aligns the component carrier structure 101 in a predefined position within the unloading. The unloading unit 130 comprises a respective loader, such as a manipulator, for gripping the respective component carrier structure 101 or a respective carrier 104 supporting the component carrier structure 101 and for moving the component carrier structure 101 to the desired location, such as a magazine and/or a carrier 104 for supporting the component carrier structure.

A further part/unit of the tracing system 102 is installed in the unloading unit 130. The tracing system 102 is configured for identifying the component carrier structure 101 delivered from the flipping unit 140 and the drilling stage 120. Furthermore, the tracing system 102 is configured for identifying for example the magazine to which the respective component carrier structure 101 has been delivered.

The component carrier structures comprise an identifier 103 and the tracing system 102 is configured for tracing a respective component carrier structure 101 by reading the identifier 103. Therefore, the tracing system 102 comprises a respective detector, such as a camera and RFID reader, for detecting the information characterizing the component carrier structure 101. Hence, the identifier 103 may be a QR, a barcode, or an RFID tag. The tracing system 102 may be connected to a control unit 150 or to a respective database for identifying the respective information for the traced component carrier structure 101. For example, based on the determined identifier 103, the respective constitution of the component carrier structure 101 and the drilled hole pattern to be drilled can be selected.

Furthermore, an inspection unit 108 is provided for presenting a component carrier structure 101 for visual inspection to a user after the first part of drilling and before the second part of drilling. The inspection unit 108 may be a separate unit that may receive the component carrier structure 101. For example, after the drilling stage 120, the component carrier structure 101 to be reviewed can be separated from the manufacturing line of the apparatus 100 and can be arranged inside the separate inspection unit 108. Hence, while inspecting the extracted component carrier structure 101, further component carrier structures 101 may be processed, i.e. drilled, and further moved to the flipping and/or the unloading. After the operator has inspected the component carrier structure 101, the component carrier structure 101 may be put back in the general drilling procedure, i.e. before the flipping unit 140. The inspection unit 108 or a further inspection unit 108 may be installed in at least one of the loader unit 110, the drilling stage 120, the unloading unit 130 and the flipping unit 140.

The communication system 160 further comprises the control unit 150 for controlling the loader unit 110, the drilling stage 120, the fixing stage, the flipping unit 140 and the unloading unit 130. The control unit 150 is coupled to the tracing system 102 for controlling the loader unit 110, the drilling stage 120 and the unloading unit 130 based on the tracing data determined by the tracing system 102. Additionally, the control unit 150 is coupled to the flipping unit 140 for controlling the flipping of a component carrier structure 101 based on the tracing information received by the tracing system 102. Furthermore, the control unit 150 is coupled to the inspection unit 108. Hence, the control unit 150 controls a handling unit 109 to move a component carrier structure 101 after the drilling stage 120 to the inspection unit 108 for inspecting the quality of the drilled holes and the component carrier structure 101, respectively. At the same time, the control unit 150 controls the drilling stage unit 120, such that simultaneously to the inspection the drilling of further component carrier structures 101 further proceed.

Furthermore, the apparatus 100 further comprises drill support exchange units 106, 107 configured for exchanging a drill support 105 to be interposed between a vacuum suction table 204 and a component carrier structure 101 during drilling. An inlet drill support exchange unit 106 is coupled to the loader unit 110 for providing drill support to the drilling stage 120 via the loader unit 110. An outlet drill support exchange unit 107 is coupled to the unloading unit 130 for receiving drill support from the drilling stage 120, e.g. via the flipping unit 140 and the unloading unit 130. Furthermore, further drill support exchange units 111 may be coupled to the drilling stage 120 and the flipping unit 140 in order to exchange a damaged drill support 105.

**Fig. 2** illustrates a schematic view of a vacuum suction table 204 holding a component carrier structure 101 in a drilling stage 120 according to an exemplary embodiment.

The component carrier structures 101 are fixed during laser drilling onto a drill support 105 in particular by vacuum and under pressure, respectively. Hence, the drill support 105 comprises vacuum through holes which are covered on the one side by the component carrier structure 101 which is located onto the drill support 105. The drill support 105 itself is arranged onto the surface of a vacuum suction table 204. The vacuum suction table 204 comprises respective through holes that are coupled to a vacuum pump. Specifically, the through holes of the drill support 105 matches with the through holes of the vacuum suction table 204. Hence, upon applying under pressure, the drill support 105 as well as the component carrier structure 101 is sucked to the vacuum suction table 204 and may therefore be fixed in the desired position. The drill supports 105 are removably located onto the vacuum suction table 204, so that the drill supports 105 may be exchanged, if the drill support 105 is damaged for example by the drilling process or if different kinds of component carrier structures 101 have to be drilled that makes different drill support 105 necessary. As can be seen in Fig. 2, if a laser beam 202 of a laser device 201 of the laser drilling stage 120 radiates through a bore hole 203 of the component carrier structure 101, damage to the drill support 105 can be caused. Furthermore, the drill support 105 may be fixed with a clamping system whenever the vacuum system is off (e.g. during component carrier exchange).

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

### Reference Numerals

- 100: apparatus
- 101: component carrier structure
- 102: tracing system
- 103: identifier
- 104: carrier
- 105: drill support
- 106: inlet drill support exchange unit
- 107: outlet drill support exchange unit
- 108: inspection unit
- 109: handling unit
- 111: further drill support exchange unit

- 110: loader unit
- 120: drilling stage
- 130: unloading unit
- 140: flipping unit
- 150: control unit
- 160: communication system

- 201: laser device
- 202: laser beam
- 203: bore hole
- 204: vacuum suction table
- 205: stage fixation

## Claims

1. Apparatus (100) for drilling component carrier structures (101), wherein the apparatus (100) comprises
a drilling stage (120) configured for drilling the component carrier structures (101) according to a drilling process;
a fixing system comprising a stage fixation (205) configured for fixing and/or aligning the component carrier structures (101) in the drilling stage (120); and
a tracing system (102) for tracing data deriving from at least one of the component carrier structures (101), the fixing system and the drilling stage (120) and/or the drilling process, and
a communication system (160) associated to the tracing system (102), wherein the communication system (160) is configured to manage the tracing data acquired by the tracing system (102).

2. Apparatus (100) according to claim 1, further comprising a loader unit (110) configured for loading component carrier structures (101) for drilling into the apparatus (100);
wherein the loader unit (110) is coupled to the communication system (160) for interchanging tracing data.

3. Apparatus (100) according to claim 1 or 2, further comprising
an unloading unit (130) configured for unloading drilled component carrier structures (101) out of the apparatus (100); and
wherein the unloading unit (130) is coupled to the communication system (160) for interchanging tracing data.

4. Apparatus (100) according to one of the claims 1 to 3,
wherein the tracing system (102) is configured for tracing a respective component carrier structure (101) by reading tracing data from an identifier (103) from the component carrier structure (101),
wherein the identifier (103) is in particular at least one of the groups consisting of a QR code, a barcode, and an alphanumeric code.

5. Apparatus (100) according to one of the claims 1 to 4,
wherein the tracing system (102) is configured for tracing tracing data of a carrier (104) carrying a plurality of component carrier structures (101) to be drilled.

6. Apparatus (100) according to claim 5,
wherein the tracing system (102) is configured for tracking the carrier (104) by reading an RFID tag of the carrier (104).

7. Apparatus (100) according to one of the claims 1 to 6, further comprising
a flipping unit (140) configured for flipping a component carrier structure (101) upside down after having drilled one main surface and before drilling the opposing other main surface of the respective component carrier structure (101),
wherein the flipping unit (140) is coupled to the communication system (160) for interchanging tracing data.

8. Apparatus (100) according to one of the claims 2 to 7,
wherein the loader unit (110) is configured to place and align the component carrier structure (101) onto a drill support (105),
wherein the drill support (105) is configured for being moved with the component carrier structure (101) at least through the drilling stage (120), such that the drill support (105) functions as a stop layer for protecting the apparatus (100),
wherein in particular the component carrier structure (101) is arranged with its main surface onto the drill support (105) for reducing the risk of warpage.

9. Apparatus (100) according to claim 8,
wherein the stage fixation (205) comprises a fixing table, in particular a vacuum suction table (204),
wherein at least one of the stage fixation (205) and the drill support (105) is fixable to the fixing table during drilling.

10. Apparatus (100) according to claim 8 or 9, further comprising
a drill support exchange unit (106, 107) configured for exchanging the drill support (105),
wherein in particular one drill support exchange unit (106) is coupled to at least one of the loader unit (110), the drilling stage (120), the flipping unit (140) and the unloading stage (130) for exchanging a drill support (105).

11. Apparatus (100) according to one of the claims 1 to 10,
wherein the tracing system (102) comprises an inspection unit (108) configured for presenting a component carrier structure (101) for visual inspection to a user after a first part of drilling,
wherein the inspection unit (108) is in particular further configured for providing a visual inspection to a user after flipping the component carrier structure (101) and after a second part of drilling or before the unloading unit (130).

12. Apparatus (100) according to one of the claims 1 to 11, further comprising
a control unit (150) coupled to the communication system (160) for controlling at least one of the drilling stage (120), the fixation system and the tracing system (102), based on the tracing data determined by the tracing system (102).

13. Apparatus (100) according to one of the claims 1 to 12,
wherein the tracing system (102) comprises a detector device, in particular an inspection camera, for determining at least one of a diameter of the bore holes (203) drilled in the component carrier structure (101) and warpage of the component carrier structure (101) or the drill support (105).

14. Apparatus (100) according to one of the claims 1 to 13,
wherein the communication system (160) is coupled to a subsequent processing system, in particular a plating system, for providing the tracing data about the component carrier structure (101).

15. Method of drilling component carrier structures (101) according to a drilling process in an automated way, wherein the method comprises:
fixing and/or aligning the component carrier structures (101) in a drilling stage (120) by a drilling stage fixation (205) of a fixing system;
drilling of component carrier structures (101) in the drilling stage (120);
tracing data deriving from at least one of the component carrier structures (101), the fixing system and the drilling process; and
interchanging tracing data by a communication system (160) associated to the apparatus configured to manage said tracing data.
